Europäisches Patentamt

European Patent Office

Office européen des brevets

(19)

(11) **EP 1 365 253 A2**

(12) # EUROPEAN PATENT APPLICATION

(43) Date of publication:
**26.11.2003 Bulletin 2003/48**

(51) Int Cl.[7]: **G01R 33/565**

(21) Application number: **03253184.0**

(22) Date of filing: **21.05.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **22.05.2002 US 153076**

(71) Applicant: **GE Medical Systems Global Technology Company LLC Waukesha, Wisconsin 53188 (US)**

(72) Inventor: **Busse, Reed San Mateo, California 94401 (US)**

(74) Representative: **Pedder, James Cuthbert GE London Patent Operation, Essex House, 12/13 Essex Street London WC2R 3AA (GB)**

(54) **Automatic field of view optimization in MR imaging for maximization of resolution and elimination of aliasing artifacts**

(57)    An automatic field of view optimization method for maximizing resolution and eliminating aliasing artifact includes the steps of measuring for an optimal field of view, acquiring images using this optimized field of view, and reconstructing images in a field of view consistent data set

FIG. 2

## Description

This invention relates to magnetic resonance (MR) imaging systems. More particularly, it relates to a method for optimizing field of view (FOV) for maximization of image resolution and for elimination of aliasing artifact.

An MR imaging system provides an image of a patient or other object in an imaging volume based on detected radio frequency (RF) signals from precessing nuclear magnetic moments. A main magnet produces a static magnetic field, or $B_0$ field, over the imaging volume. Similarly, gradient coils within the MR imaging system are employed to strengthen or weaken the static magnetic field in a spatial dependent manner, typically along mutually orthogonal x, y, z coordinates during selected portions of an MR imaging data acquisition cycle. Meanwhile, an RF coil produces RF magnetic field pulses, referred to as a $B_1$ field, perpendicular to the $B_0$ field, within the imaging volume to excite the nuclei. The nuclei are thereby excited to precess about an axis parallel to the $B_0$ field at a resonant RF frequency proportional to the magnetic field strength at a given time and spatial location. As the precession occurs in the transverse plane, the transverse component of magnetization is magnetically coupled to some external circuitry, typically a receiver. These transmitter and receiver coupling mechanisms both are called RF coils. RF coils are tuned to resonate in a frequency band centered about the Larmor frequency of magnetic moments precessing in the static field.

In normal practice, the prescribed FOV is typically based on reasonable guess as to the patient's dimensions or a fixed protocol. If the FOV prescribed is smaller than the actual extent of the patient, aliasing may occur in the phase encode direction. If the FOV prescribed is larger than the actual extent of the patient, resolution may be less than optimal. The optimal FOV would precisely match the dimensions of the patient, thus maximizing resolution while eliminating aliasing. For multislice acquisitions, the optimal FOV may vary from slice to slice.

The method presented here addresses the problem of efficiently determining the optimal FOV on a per-slice basis, acquiring data using this optimal FOV, and reconstructing images for a field-of-view consistent data set.

There are three parts to the method of the invention. First, there is a measurement of the optimal FOV. Next, there is the acquisition of images using this optimized FOV. Lastly, there is the reconstruction of images in a FOV-consistent data set. Each of these steps will be discussed in further detail. It is anticipated by this inventor that application of the method of the present invention will provide improved resolution and reduce the number of incidents of phase-wrap aliasing present in current methods.

In addition to traditional multi-slice imaging, the technique may also be applied to 3D and moving-table acquisitions. For 3D acquisitions, only one measurement of the optimal FOV is made per slab and the entire slab is acquired with this single optimized FOV, rather than on a per-slice basis. For multi-slab acquisitions (such as MOTSA), each slab has an individual, optimized FOV.

For axial multi-slice moving table applications, straightforward application of the described technique would require the patient be moved through the scanner to measure the optimal FOV and then again during imaging. A more advanced application would combine the FOV measurement and image acquisition - the FOV measurement would be interleaved with image acquisitions, possibly measuring several slices ahead to allow magnetization time to recover before image acquisition.

For non-axial 2D and 3D moving-table applications, continuously changing the FOV while the patient moved through the scanner would create a non-uniformly sampled k-space which could be reconstructed by regridding.

The use of slice or slab projections to determine the field-of-view is novel. The use of any data acquired with MR to automatically optimize the field-of-view is novel. The use of interpolation to combine images acquired at different fields of view into a single dataset is novel.

The invention will now be described in greater detail, by way of example, with reference to the drawings, in which:-

FIG. 1 is a graphical representation of the pulse sequence initiated by the method of the present invention.

FIG. 2 is a schematic representation of the projection profiles and boundary determination of the method of the present invention.

As previously alluded to, normal imaging practice is that the prescribed FOV is based on a reasonable guess as to the patient's dimensions or a fixed protocol. If the FOV prescribed is smaller than the actual extent of the patient, aliasing may occur in the phase encode direction. If the FOV prescribed is larger than the actual extent of the patient, resolution may be less than optimal. The optimal FOV would precisely match the dimensions of the patient, thus maximizing resolution while eliminating aliasing. For multislice acquisitions, the optimal FOV may vary from slice to slice. The method presented here addresses the problem of efficiently determining the optimal FOV on a per-slice basis, acquiring data using this optimal FOV, and reconstructing images for a FOV-consistent data set.

The three parts to this method are as follows:

1. Determination of optimal FOV;

2. Acquisition of images with optimized FOV; and

3. Reconstruction of images in a FOV-consistent data set.

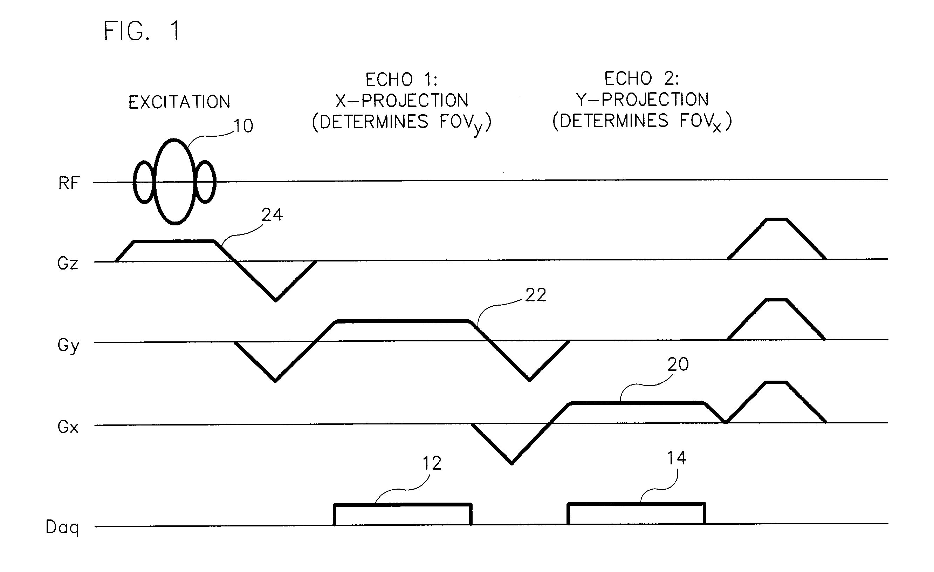

With regards to the first step, there are many ways that the optimal field of view might be determined, including manual or automatic analysis of previously acquired images. In the preferred embodiment, however, a simple and fast *projection prescan* method would be used. The projection prescan consists of exciting each slice (which will later be acquired during image acquisition) in order to acquire projections along the logical and x- and y-axes 12, 14. A pulse sequence to accomplish this is shown in Figure 1 wherein $G_x$, $G_y$ and $G_z$ represent the magnetic field gradient waveforms 20, 22, 24 in the x, y and z directions, respectively.

The projection field of view must accommodate the maximum possible extent of the patient. Since the resolution requirement of the projection is low, the projection field of view should be set to a large amount, such as 50cm. Small tip angle excitation could be used (e.g. 10 degrees) so as not to disturb magnetization for later imaging.

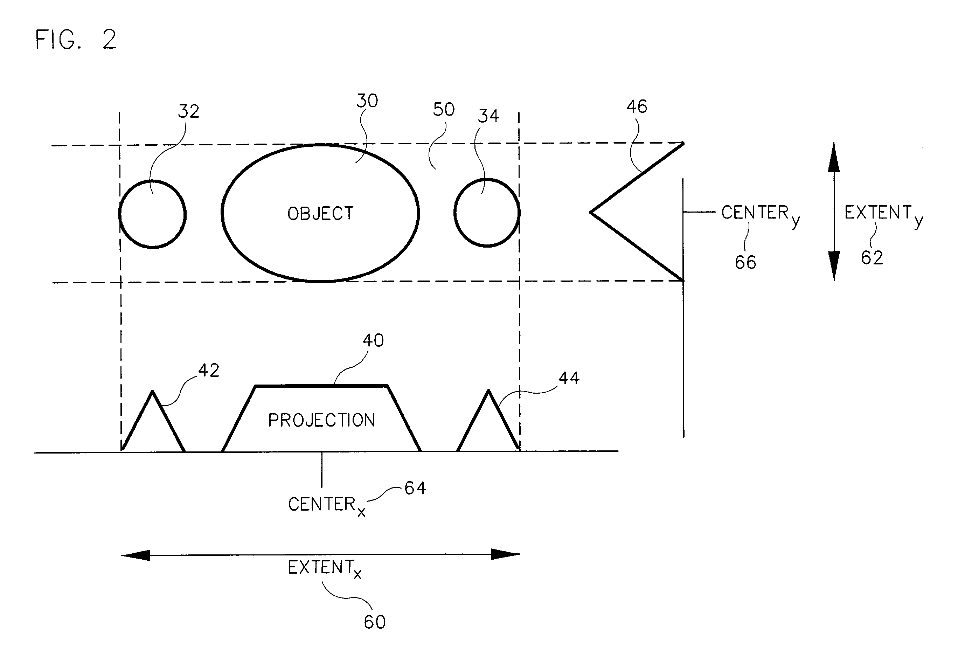

Fourier transformation of each echo will produce a 1-dimensional projection 40, 42, 44, 46 of the 2-dimensional slice 50. A boundary determination algorithm will operate on each projection to determine the extent of the object 30, 32 34 in the given dimension and the center of the object in each slice 50, as shown in Figure 2. This information illustrated as ($extent_x$ 60, $extent_y$ 62, $center_x$ 64, $center_y$ 66) will be passed along, to be used in image data acquisition.

The second step requires that, for each slice 50, a number of parameters be altered to take advantage of the information gleaned from the projection prescan data. First, the demodulation frequency and phase-encode phase-roll will be adjusted to place the center of the object 30, 32, 34 in the center of the FOV. Second, the frequency and phase-encode gradient pulse amplitudes and areas will be scaled to produce the desired FOV 50.

It is assumed that the number of phase-encodes (and number of samples acquired per echo) remains constant for all slices. If this is the case, pixel size varies with FOV, thus resolution decreases as FOV increases. An extension of this technique would be to make the number of phase encodes and (possibly the number of samples acquired per echo) increase in proportion to the FOV. This would maintain constant resolution (pixel size) in all slices.

To implement this method in a straight-forward manner, the preferred embodiment is one in which the operator will indicate a minimum allowable FOV, and a fixed number of phase-encodes and samples per echo. Gradient waveforms 20, 22, 24 will be calculated based on this minimum FOV, but then reduced in amplitude on a per-slice basis in order to accommodate objects 20 whose extent is larger than this minimum FOV. The amount that the gradient waveform amplitudes are reduced is

$$G_x\_scale = min\_FOV_x / extent_x$$

$$G_y\_scale = min\_FOV_y / extent_y$$

In some cases, such as sagittal and coronal sections where the object extends beyond the desired field of view in the frequency-encode direction, field-of-view optimization could take place only along the phase-encode direction.

With respect to the third step, the reconstruction of images with consistent FOV, one result of scaling frequency and phase-encode gradient amplitudes is that the Fourier reconstructed images will appear to be "squished" to fit into the FOV. This is exactly as desired, but they must then be restored to their correct size and proportion. This may be accomplished by interpolation. As the corner points for each slice are known, this interpolation may be performed prior to, or preferably, in combination with correcting for geometric distortion due to gradient non-linearities (GradWarp). In order not to lose resolution in the interpolation process, it is recommended that the original Fourier reconstruction be performed on an extended matrix with zero filling (512 zip).

In addition to traditional multi-slice imaging, the technique may also be applied to 3D and moving-table acquisitions. For 3D acquisitions, only one projection pair is measured per slab and the entire slab is acquired with a single optimized FOV, rather than on a per-slice basis. For multi-slab acquisitions (such as MOTSA), each slab would have an individual, optimized FOV.

For axial multi-slice moving table applications, straightforward application of the described technique would require the patient be moved through the scanner during projection prescan and then again during imaging. A more advanced application would combine the prescan and acquisition - the projection prescan would be interleaved with image acquisitions, possibly prescanning several slices ahead to allow magnetization time to recover before image acquisition.

For non-axial 2D and 3D moving-table applications, continuously changing the FOV while the patient moved through the scanner would create a non-uniformly sampled k-space which could be reconstructed by regridding.

The use of slice or slab projections to determine the field-of-view is novel. The use of any data acquired with MR to automatically optimize the field-of-view is novel. The use of interpolation to combine images acquired at different fields of view into a single dataset is novel.

For the sake of good order, various aspects of the invention are set out in the following clauses:-

1. An MR imaging method for optimizing the field of view (50) in an image volume, the steps comprising:

   a) determining an optimal field of view (50);
   b) acquiring images with the optimized field of view (50); and
   c) reconstructing images in a field of view consistent data set;

   wherein image resolution is maximized and aliasing artifact is eliminated.

2. The method as recited in clause 1 wherein the optimal field of view (50) is determined by use of a projection prescan method.

3. The method as recited in clause 2 wherein the projection prescan method consists of exciting (10) each slice (50) of the image volume for the purpose of acquiring projections along the logical x and y axes (12, 14).

4. The method as recited in clause 3 wherein a small tip angle excitation is utilized.

5. The method as recited in clause 4 wherein a Fourier transformation of each echo is utilized to produce a one-dimensional projection (40, 42, 44, 46) of a two dimensional slice (50).

6. The method as recited in clause 5 wherein a boundary determination algorithm operates on each projection to determine the extent of the object (30, 32, 34) in the given dimension and the center of the object in each slice (50).

7. The method as recited in clause 6 wherein the information determined is $extent_x$ (60), $extent_y$ (62), $center_x$ (64) and $center_y$ (66) which information is passed along to be used in image data acquisition.

8. The method as recited in clause 7 wherein the demodulation frequency and phase-encode phase-roll are adjusted to place the center of the object (30, 32, 34) in the center of the field of view (50).

9. The method as recited in clause 8 wherein the frequency and phase-encode gradient pulse amplitudes and areas are scaled to produce a desired field of view (50).

10. The method as recited in clause 9 wherein a minimum allowable field of view (50) is indicated and a fixed number of phase-encodes and samples per echo are indicated.

11. The method as recited in clause 9 wherein a minimum allowable field of view (50) is indicated and the number of phase-encodes and/or samples per echo are proportional to the desired field of view (50) in order to maintain fixed resolution (pixel dimension) after image reconstruction.

12. The method as recited in clause 10 wherein gradient wave forms (20, 22, 24) are calculated based on the minimum field of view (50) and then reduced in amplitude on a per-slice basis.

13. The method as recited in clause 11 wherein the amount that the gradient wave form amplitudes are reduced is in accordance with the formulas $G_x\_scale = min\text{-}FOV_x/extent_x$ and $G_y\_scale = min\text{-}FOV_y/extent_y$.

14. The method as recited in clause 12 wherein the images are reconstructed to correct size and proportion.

15. The method as recited in clause 13 wherein image reconsruction is accomplished by interpolation.

16. A method for optimizing the field of view (FOV) (50) in an image volume, said method being used in a magnetic resonance (MR) imaging system, comprising the steps of

   a) using a projection pre-scan method for measuring an optimal FOV (50);
   b) acquiring images with the optimized FOV (50); and
   c) reconstructing images in a FOV-consistent data set;

   wherein image resolution is maximized and aliasing artifact is eliminated.

17. The method as recited in clause 15 wherein the FOV measuring step includes the additional steps of exciting (10) each slice (50) of the image volume for the purpose of acquiring projections along the logical x and y axes (12, 14) and utilizing a small tip angle excitation.

18. The method as recited in clause 16 wherein the imaging acquiring step includes the additional steps of adjusting the demodulation frequency and phase-encode phase-roll to place the center of the object (30, 32, 34) in the center of the FOV (50) and scaling the frequency and phase-encode gradient pulse amplitudes to produce a desired FOV (50).

19. The method as recited in clause 17 wherein the image reconstructing step includes the additional step of reconstructing the images to correct size and proportion by use of interpolation.

20. An MR imaging method for optimizing a field of view (FOV) (50) that matches the dimensions of a patient, whereby resolution is maximized and aliasing is eliminated, comprising the steps of

a) using a projection pre-scan method for measuring an optimal FOV (50);
b) acquiring images with the optimized FOV (50); and
c) reconstructing images in a FOV-consistent data set.

21. The method as recited in clause 19 wherein the FOV measuring step includes the additional steps of exciting (10) each slice (50) of the image volume for the purpose of acquiring projections along the logical x and y axes (12, 14) and utilizing a small tip angle excitation.

22. The method as recited in clause 20 wherein the imaging acquiring step includes the additional steps of adjusting the demodulation frequency and phase-encode phase-roll to place the center of the object (30, 32, 34) in the center of the FOV (50) and scaling the frequency and phase-encode gradient pulse amplitudes to produce a desired FOV (50).

23. The method as recited in clause 21 wherein the image reconstructing step includes the additional step of reconstructing the images to correct size and proportion by use of interpolation.

24. For use with three dimensional acquisitions in MR imaging, a method for optimizing the field of view (50) in an image volume comprising the steps of:

a) using a projection prescan method for measuring an optimal field of view (50);
b) acquiring images with the optimized field of view (50); and
c) reconstructing images in a field of view consistent data set;

wherein only one projection pair is measured per slab and the entire slab is acquired with a single optimized field of view (50).

25. The method as recited in clause 23 wherein the imaging acquiring step includes the additional steps of adjusting the demodulation frequency and phase-encode phase-roll to place the center of the object (30, 32, 34) in the center of the FOV (50) and scaling the frequency and phase-encode gradient pulse amplitudes to produce a desired FOV (50).

26. The method as recited in clause 24 wherein the image reconstructing step includes the additional step of reconstructing the images to correct size and proportion by use of interpolation.

27. For use in moving table acquisitions in MR imaging, a method for optimizing the field of view (50) in an image volume comprising the steps of:

a) using a projection prescan method for measuring an optimal field of view (50);
b) acquiring images with the optimized field of view (50); and
c) reconstructing images in a field of view consistent data set;

wherein the image volume is moved through a scanner during projection prescan and then again during imaging.

28. The method as recited in clause 26 wherein the imaging acquiring step includes the additional steps of adjusting the demodulation frequency and phase-encode phase-roll to place the center of the object (30, 32, 34) in the center of the FOV (50) and scaling the frequency and phase-encode gradient pulse amplitudes to produce a desired FOV (50).

29. The method as recited in clause 27 wherein the image reconstructing step includes the additional step of reconstructing the images to correct size and proportion by use of interpolation.

30. The method as recited in clause 28 wherein the projection prescan is interleaved with image acquisitions.

**Claims**

1. An MR imaging method for optimizing the field of view (50) in an image volume, the steps comprising:

a) determining an optimal field of view (50);
b) acquiring images with the optimized field of view (50); and
c) reconstructing images in a field of view consistent data set;

wherein image resolution is maximized and aliasing artifact is eliminated.

2. The method as recited in claim 1 wherein the optimal field of view (50) is determined by use of a projection prescan method.

3. A method for optimizing the field of view (FOV) (50) in an image volume, said method being used in a magnetic resonance (MR) imaging system, comprising the steps of

a) using a projection pre-scan method for measuring an optimal FOV (50);
b) acquiring images with the optimized FOV (50); and
c) reconstructing images in a FOV-consistent data set;

wherein image resolution is maximized and aliasing artifact is eliminated.

4. The method as recited in claim wherein the FOV measuring step includes the additional steps of exciting (10) each slice (50) of the image volume for the purpose of acquiring projections along the logical x and y axes (12, 14) and utilizing a small tip angle excitation.

5. An MR imaging method for optimizing a field of view (FOV) (50) that matches the dimensions of a patient, whereby resolution is maximized and aliasing is eliminated, comprising the steps of

a) using a projection pre-scan method for measuring an optimal FOV (50);
b) acquiring images with the optimized FOV (50); and
c) reconstructing images in a FOV-consistent data set.

6. The method as recited in claim 5 wherein the FOV measuring step includes the additional steps of exciting (10) each slice (50) of the image volume for the purpose of acquiring projections along the logical x and y axes (12, 14) and utilizing a small tip angle excitation.

7. A method for optimizing the field of view (50) in an image volume for use with three dimensional acquisitions in MR imaging comprising the steps of:

a) using a projection prescan method for measuring an optimal field of view (50);
b) acquiring images with the optimized field of view (50); and
c) reconstructing images in a field of view consistent data set;

wherein only one projection pair is measured per slab and the entire slab is acquired with a single optimized field of view (50).

8. The method as recited in claim 7 wherein the imaging acquiring step includes the additional steps of adjusting the demodulation frequency and phase-encode phase-roll to place the center of the object (30, 32, 34) in the center of the FOV (50) and scaling the frequency and phase-encode gradient pulse amplitudes to produce a desired FOV (50).

9. A method for optimizing the field of view (50) in an image volume for use in moving table acquisitions in MR imaging comprising the steps of:

a) using a projection prescan method for measuring an optimal field of view (50);
b) acquiring images with the optimized field of view (50); and
c) reconstructing images in a field of view consistent data set;

wherein the image volume is moved through a scanner during projection prescan and then again during imaging.

10. The method as recited in claim 9 wherein the imaging acquiring step includes the additional steps of adjusting the demodulation frequency and phase-encode phase-roll to place the center of the object (30, 32, 34) in the center of the FOV (50) and scaling the frequency and phase-encode gradient pulse amplitudes to produce a desired FOV (50).

FIG. 1

EXCITATION

ECHO 1:
X-PROJECTION
(DETERMINES $FOV_y$)

ECHO 2:
Y-PROJECTION
(DETERMINES $FOV_x$)

RF

Gz

Gy

Gx

Daq

EP 1 365 253 A2

# FIG. 2